# EUROPEAN PATENT SPECIFICATION

(11) **EP 3 941 253 B1**
(45) Date of publication and mention of the grant of the patent: **18.06.2025**
(21) Application number: 20715695.1
(22) Date of filing: 13.03.2020
(51) Int. Cl.: A24F 47/00, H05K 1/02, H02J 7/00, H02M 3/00

(54) **SMOKING SUBSTITUTE SYSTEM**
RAUCHERSATZSYSTEM
SYSTÈME DE SUBSTITUTION DU TABAC

(30) Priority: 22.03.2019 EP 19020150
(43) Date of publication of application: 26.01.2022
(73) Proprietor: Imperial Tobacco Limited, Bristol, BS3 2LL (GB)
(72) Inventor: BENYEZZAR, Med, Liverpool Merseyside L24 9HP (GB); ZITZKE, Roland, Liverpool Merseyside L24 9HP (GB); LORD, Chris, Liverpool Merseyside L24 9HP (GB)
(74) Representative: Mewburn Ellis LLP
(86) International application number: PCT/EP2020/056772
(87) International publication number: WO 2020/193175

(56) References cited:
- US-A1- 2014 254 055
- US-A1- 2016 057 811
- US-A1- 2017 347 712
- US-A1- 2018 027 878

## Description

### TECHNICAL FIELD

The present invention relates to a smoking substitute system and particularly, although not exclusively, to a smoking substitute system comprising a heated tobacco device.

### BACKGROUND

The smoking of tobacco is generally considered to expose a smoker to potentially harmful substances. It is generally thought that a significant amount of the potentially harmful substances are generated through the heat caused by the burning and/or combustion of the tobacco and the constituents of the burnt tobacco in the tobacco smoke itself.

Conventional combustible smoking articles, such as cigarettes, typically comprise a cylindrical rod of tobacco comprising shreds of tobacco which is surrounded by a wrapper, and usually also a cylindrical filter axially aligned in an abutting relationship with the wrapped tobacco rod. The filter typically comprises a filtration material which is circumscribed by a plug wrap. The wrapped tobacco rod and the filter are joined together by a wrapped band of tipping paper that circumscribes the entire length of the filter and an adjacent portion of the wrapped tobacco rod. A conventional cigarette of this type is used by lighting the end opposite to the filter, and burning the tobacco rod. The smoker receives mainstream smoke into their mouth by drawing on the mouth end or filter end of the cigarette.

Combustion of organic material such as tobacco is known to produce tar and other potentially harmful by-products. There have been proposed various smoking substitute systems (or "substitute smoking systems") in order to avoid the smoking of tobacco.

Such smoking substitute systems can form part of nicotine replacement therapies aimed at people who wish to stop smoking and overcome a dependence on nicotine.

Smoking substitute systems include electronic systems that permit a user to simulate the act of smoking by producing an aerosol (also referred to as a "vapour") that is drawn into the lungs through the mouth (inhaled) and then exhaled. The inhaled aerosol typically bears nicotine and/or flavourings without, or with fewer of, the odour and health risks associated with traditional smoking.

In general, smoking substitute systems are intended to provide a substitute for the rituals of smoking, whilst providing the user with a similar experience and satisfaction to those experienced with traditional smoking and with combustible tobacco products. Some smoking substitute systems use smoking substitute articles (also referred to as a "consumables") that are designed to resemble a traditional cigarette and are cylindrical in form with a mouthpiece at one end.

The popularity and use of smoking substitute systems has grown rapidly in the past few years. Although originally marketed as an aid to assist habitual smokers wishing to quit tobacco smoking, consumers are increasingly viewing smoking substitute systems as desirable lifestyle accessories.

There are a number of different categories of smoking substitute systems, each utilising a different smoking substitute approach.

One approach for a smoking substitute system is the so-called Heated Tobacco ("HT") approach in which tobacco (rather than an "e-liquid") is heated or warmed to release vapour. HT is also known as "heat not burn" ("HNB"). The tobacco may be leaf tobacco or reconstituted tobacco. The vapour may contain nicotine and/or flavourings. In the HT approach the intention is that the tobacco is heated but not burned, i.e. the tobacco does not undergo combustion.

A typical HT smoking substitute system may include a device and a consumable. The consumable may include the tobacco material. The device and consumable may be configured to be physically coupled together. In use, heat may be imparted to the tobacco material by a heating element of the device, wherein airflow through the tobacco material causes components in the tobacco material to be released as vapour. A vapour may also be formed from a carrier in the tobacco material (this carrier may for example include propylene glycol and/or vegetable glycerine) and additionally volatile compounds released from the tobacco. The released vapour may be entrained in the airflow drawn through the tobacco.

As the vapour passes through the consumable (entrained in the airflow) from the location of vaporisation to an outlet of the consumable (e.g. a mouthpiece), the vapour cools and condenses to form an aerosol for inhalation by the user. The aerosol will normally contain the volatile compounds.

In HT smoking substitute systems, heating as opposed to burning the tobacco material is believed to cause fewer, or smaller quantities, of the more harmful compounds ordinarily produced during smoking. Consequently, the HT approach may reduce the odour and/or health risks that can arise through the burning, combustion and pyrolytic degradation of tobacco.

There may be a need for improved design of smoking substitute systems, in particular HT smoking substitute systems, to enhance the user experience and improve the function of the HT smoking substitute system. US 2017/347712A proposes an apparatus for heating smokable material. US2018/027878A proposes an electronic vaping device, battery section and charger. US 2014/254055A proposes an over current and short circuit protection device for an electronic cigarette. US 2016/057811 proposes a method, system and device for controlling a heating element.

The present disclosure has been devised in the light of the above considerations.

### SUMMARY OF THE INVENTION

At its most general, the present invention relates to a heated tobacco device, including a multilayer printed circuit board (PCB).

According to a first aspect, there is provided a heated tobacco device as set out in claim 1.

The provision of separate power and ground layers may provide noise insulation, signal integrity and an efficient distribution of power.

Optional features will now be set out. These are applicable singly or in any combination with any aspect.

The power and ground layers are sandwiched between the top and bottom layers. Each of the layers (which may be formed of e.g. copper sheet) may be separated by an insulative layer to provide electrical insulation between the layers. One or more of the layers may be separated by a dialetric layer. One or more of the layers may be separated by a prepreg layer. A plurality of components (e.g. resistors, transistors, microprocessors, etc.) may be mounted to the top and/or bottom layers. The top and bottom layers may each comprise a plurality of traces (or paths) electrically connecting the components mounted thereto. One or both of the top and bottom layers may be electrically connected to the power and ground layers.

The device may comprise a voltage regulator to regulate the voltage supplied by the power source to a regulated voltage value at an output of the voltage regulator. The power layer may be connected to the output of the voltage regulator. This may ensure a consistent voltage is supplied to the power layer.

The device may comprise a first heater control transistor configured to control (e.g. by switching between an "on" and an "off" state) the supply of power to the heater from the power source. The device may further comprise a second heater control transistor connected in series with the first transistor. The first and/or second transistor may be a metal-oxide-semiconductor field-effect transistor (MOSFET). The second transistor may be configured to control the supply of power to the heater from the power source. The heater may be controlled using pulse width modulation. Thus, the transistors may be turned on an off according to a duty cycle. The duty cycle may be altered to alter the temperature of the heater.

The first and second transistors may both be on the return path from the heater to the power source. Alternatively, the first transistor may be on the forward path from the power source to the heater and the second transistor may be on the return path. Alternatively, both transistors may be on the forward path. The use of two transistors may increase the reliability of the device. For example, if one transistor becomes "stuck" in an on position, the other transistor may ensure that an instruction to stop the supply of power (e.g. from a controller) is still acted upon.

The device may comprise a controller connected to a first drive input of the first transistor. The controller may be connected to a second drive input of the second transistor. Thus the controller may be configured to control (e.g. control switching of) the first and second transistors.

The first drive input and the second drive input may be connected to the same output of the controller. Thus, the first and second transistors may be controlled in a simultaneous manner.

The first drive input and the second drive input may be connected to different outputs of the controller. In this respect, the first and second transistors may be controlled in a different manner to one another. In some cases the two outputs of the controller may provide the same signal or instruction. In such cases, the use of the two separate outputs may provide redundancy in the system.

The heater may comprise a heating track. The PCB may comprise a heater analog-to-digital converter (HADC) connected to the heater. The controller may be configured to identify a short circuit in the heating track of the heater using the input to the HADC. The controller may be configured to detect changes in the resistance (or impedance) of the heating track. The controller may be configured to determine whether the impedance or resistance of heater falls below a threshold value. The controller may be configured to control the heater in response to the identification of a short circuit in the heating track.

The heater may comprise a temperature sensing track for sensing a temperature of the heater, the PCB comprising a temperature sensing analog-to-digital converter (TSADC) connected to the temperature sensing track. The controller may be configured to determine the temperature of the temperature sensing track using the input to the TSADC. The controller may be configured to determine the temperature of the sensing track using the output from the TSADC.

The controller may be configured to compare the determined temperature with a threshold temperature and control the heater in response to the comparison. The controller may be configured to determine if the impedance of the temperature sensing track is outside a predetermined operating range, and to prevent power supply to the heater if the impedance is outside the predetermined operating range.

The device may comprise an elongate body. An end of the elongate body may be configured for engagement with an aerosol-forming article (e.g. a heated tobacco (HT) consumable). The device may comprise a cavity that is configured for receipt of at least a portion of the consumable (i.e. for engagement with the consumable). The aerosol-forming article may be of the type that comprises an aerosol former (e.g. carried by an aerosol-forming substrate).

The heater may comprise a heating element, which may be in the form of a rod that extends from the body of the device. The heating element may extend from the end of the body that is configured for engagement with the aerosol-forming article.

The heater (and thus the heating element) may be rigidly mounted to the body. The heating element may be elongate so as to define a longitudinal axis and may, for example, have a transverse profile (i.e. transverse to a longitudinal axis of the heating element) that is substantially circular (i.e. the heating element may be generally cylindrical). Alternatively, the heating element may have a transverse profile that is rectangular (i.e. the heater may be a "blade heater"). The heating element may alternatively be in the shape of a tube (i.e. the heater may be a "tube heater"). The heating element may take other forms (e.g. the heating element may have an elliptical transverse profile). The shape and/or size (e.g. diameter) of the transverse profile of the heating element may be generally consistent for the entire length (or substantially the entire length) of the heating element.

The heating element may be between 15 mm and 25 mm long, e.g. between 18 mm and 20 mm long, e.g. around 19 mm long. The heating element may have a diameter of between 1.5 mm and 2.5 mm, e.g. a diameter between 2 mm and 2.3 mm, e.g. a diameter of around 2.15 mm.

The heating element may be formed of ceramic. The heating element may comprise a core (e.g. a ceramic core) comprising Al2O3. The core of the heating element may have a diameter of 1.8 mm to 2.1 mm, e.g. between 1.9 mm and 2 mm. The heating element may comprise an outer layer (e.g. an outer ceramic layer) comprising Al2O3. The thickness of the outer layer may be between 160 µm and 220 µm, e.g. between 170 µm and 190 µm, e.g. around 180 µm. The heating element may comprise a heating track, which may extend longitudinally along the heating element. The heating track may be sandwiched between the outer layer and the core of the heating element. The heating track is an electrically conductive resistive heating track comprising a pair of heater electrodes (not shown) connected to the power supply of the heater. The heating track may comprise tungsten and/or rhenium. The heating track may have a thickness of around 20 µm.

The heating element may be located in the cavity (of the device), and may extend (e.g. along a longitudinal axis) from an internal base of the cavity towards an opening of the cavity. The length of the heating element (i.e. along the longitudinal axis of the heater) may be less than the depth of the cavity. Hence, the heating element may extend for only a portion of the length of the cavity. That is, the heating element may not extend through (or beyond) the opening of the cavity.

The heating element may be configured for insertion into an aerosol-forming article (e.g. a HT consumable) when an aerosol-forming article is received in the cavity. In that respect, a distal end (i.e. distal from a base of the heating element where it is mounted to the device) of the heating element may comprise a tapered portion, which may facilitate insertion of the heating element into the aerosol-forming article. The heating element may fully penetrate an aerosol-forming article when the aerosol-forming article is received in the cavity. That is, the entire length, or substantially the entire length, of the heating element may be received in the aerosol-forming article.

The heating element may have a length that is less than, or substantially the same as, an axial length of an aerosol-forming substrate forming part of an aerosol-forming article (e.g. a HT consumable). Thus, when such an aerosol-forming article is engaged with the device, the heating element may only penetrate the aerosol-forming substrate, rather than other components of the aerosol-forming article. The heating element may penetrate the aerosol-forming substrate for substantially the entire axial length of the aerosol forming-substrate of the aerosol-forming article. Thus, heat may be transferred from (e.g. an outer circumferential surface of) the heating element to the surrounding aerosol-forming substrate, when penetrated by the heating element. That is, heat may be transferred radially outwardly (in the case of a cylindrical heating element) or e.g. radially inwardly (in the case of a tube heater).

Where the heater is a tube heater, the heating element of the tube heater may surround at least a portion of the cavity. When the portion of the aerosol-forming article is received in the cavity, the heating element may surround a portion of the aerosol-forming article (i.e. so as to heat that portion of the aerosol-forming article). In particular, the heating element may surround an aerosol forming substrate of the aerosol-forming article. That is, when an aerosol-forming article is engaged with the device, the aerosol forming substrate of the aerosol-forming article may be located adjacent an inner surface of the (tubular) heating element. When the heating element is activated, heat may be transferred radially inwardly from the inner surface of the heating element to heat the aerosol forming substrate.

The cavity may comprise a (e.g. circumferential) wall (or walls) and the (tubular) heating element may extend around at least a portion of the wall(s). In this way, the wall may be located between the inner surface of the heating element and an outer surface of the aerosol-forming article. The wall (or walls) of the cavity may be formed from a thermally conductive material (e.g. a metal) to allow heat conduction from the heating element to the aerosol-forming article. Thus, heat may be conducted from the heating element, through the cavity wall (or walls), to the aerosol-forming substrate of an aerosol-forming article received in the cavity.

The heater also comprises an electrically conductive temperature measurement track and corresponding pair of temperature measurement electrodes connected to a controller of the device. In one aspect, the temperature measurement track is formed with tungsten.

In some embodiments the device may comprise a cap disposed at the end of the body that is configured for engagement with an aerosol-forming article. Where the device comprises a heater having a heating element, the cap may at least partially enclose the heating element. The cap may be moveable between an open position in which access is provided to the heating element, and a closed position in which the cap at least partially encloses the heating element. The cap may be slideably engaged with the body of the device, and may be slideable between the open and closed positions.

The cap may define at least a portion of the cavity of the device. That is, the cavity may be fully defined by the cap, or each of the cap and body may define a portion of the cavity. The cap may comprise an opening to the cavity. The opening may be configured for receipt of at least a portion of an aerosol-forming article. That is, an aerosol-forming article may be inserted through the opening and into the cavity (so as to be engaged with the device).

The cap may be configured such that when an aerosol-forming article is engaged with the device (e.g. received in the cavity), only a portion of the aerosol-forming article is received in the cavity. That is, a portion of the aerosol-forming article (not received in the cavity) may protrude from (i.e. extend beyond) the opening. This (protruding) portion of the aerosol-forming article may be a terminal (e.g. mouth) end of the aerosol-forming article, which may be received in a user's mouth for the purpose of inhaling aerosol formed by the device.

The device comprises a power source. The power source may be electrically connectable to the heater. In that respect, altering (e.g. toggling) the electrical connection of the power source to the heater may affect a state of the heater. For example, toggling the electrical connection of the power source to the heater may toggle the heater between an on state and an off state. The power source may be a power store. For example, the power source may be a battery or rechargeable battery (e.g. a lithium ion battery).

The device may comprise an input connection (e.g. a USB port, Micro USB port, USB-C port, etc.). The input connection may be configured for connection to an external source of electrical power, such as a mains electrical supply outlet. The input connection may, in some cases, be used as a substitute for an internal power source (e.g. battery or rechargeable battery). That is, the input connection may be electrically connectable to the heater (for providing power to the heater). Hence, in some forms, the input connection may form at least part of the power source of the device. The input connection may be connected to the PCB.

Where the power source comprises a rechargeable power source (such as a rechargeable battery), the input connection may be used to charge and recharge the power source.

The device may comprise a user interface (UI). In some embodiments the UI may include input means to receive operative commands from the user. The UI may be connected to the PCB. The input means of the UI may allow the user to control at least one aspect of the operation of the device. In some embodiments the input means may comprise a power button to switch the device between an on state and an off state.

In some embodiments the UI may additionally or alternatively comprise output means to convey information to the user. In some embodiments the output means may comprise a light to indicate a condition of the device (and/or the aerosol-forming article) to the user. The condition of the device (and/or aerosol-forming article) indicated to the user may comprise a condition indicative of the operation of the heater. For example, the condition may comprise whether the heater is in an off state or an on state. In some embodiments, the UI unit may comprise at least one of a button, a display, a touchscreen, a switch, a light, and the like. For example, the output means may comprise one or more (e.g. two, three, four, etc.) light-emitting diodes ("LEDs") that may be located on the body of the device.

The device may further comprise a puff sensor (e.g. airflow sensor), which form part of the input means of the UI. The puff sensor may be operatively connected to the PCB. The puff sensor may be configured to detect a user drawing on an end (i.e. a terminal (mouth) end) of the aerosol-forming article. The puff sensor may, for example, be a pressure sensor or a microphone. The puff sensor may be configured to produce a signal indicative of a puff state. The signal may be indicative of the user drawing (an aerosol from the aerosol-forming article) such that it is e.g. in the form of a binary signal. Alternatively or additionally, the signal may be indicative of a characteristic of the draw (e.g. a flow rate of the draw, length of time of the draw, etc).

The device may comprise a controller, or may be connectable to a controller that may be configured to control at least one function of the device. The controller may comprise a microcontroller that may e.g. be mounted on the PCB. The controller may comprise a plurality of microcontrollers. The controller may also comprise a memory, e.g. non-volatile memory. The memory may include instructions, which, when implemented, may cause the controller to perform certain tasks or steps of a method. Where the device comprises an input connection, the controller may be connected to the input connection.

The device may further comprise a voltage regulator to regulate the output voltage supplied by the power source to form a regulated voltage. The regulated voltage may subsequently be applied to the heater.

In some embodiments, where the device comprises a UI, the controller may be operatively connected to one or more components of the UI. The controller may be configured to receive command signals from an input means of the UI. The controller may be configured to control the heater in response to the command signals. For example, the controller may be configured to receive "on" and "off" command signals from the UI and, in response, may control the heater so as to be in a corresponding on or off state.

The controller may be configured to send output signals to a component of the UI. The UI may be configured to convey information to a user, via an output means, in response to such output signals (received from the controller). For example, where the device comprises one or more LEDs, the LEDs may be operatively connected to the controller. Hence, the controller may be configured to control the illumination of the LEDs (e.g. in response to an output signal). For example, the controller may be configured to control the illumination of the LEDs according to (e.g. an on or off) state of the heater.
Where the device comprises a sensor (e.g. a puff/airflow sensor), the controller may be operatively connected to the sensor. The controller may be configured to receive a signal from the sensor (e.g. indicative of a condition of the device and/or engaged aerosol-forming article). The controller may be configured to control the heater, or an aspect of the output means, based on the signal from the sensor.

The device may comprise a wireless interface configured to communicate wirelessly (e.g. via Bluetooth (e.g. a Bluetooth low-energy connection) or Wi-Fi) with an external device. Similarly, the input connection may be configured for wired connection to an external device so as to provide communication between the device and the external device.

The external device may be a mobile device. For example, the external device may be a smart phone, tablet, smart watch, or smart car. An application (e.g. app) may be installed on the external device (e.g. mobile device). The application may facilitate communication between the device and the external device via the wired or wireless connection.

The wireless or wired interface may be configured to transfer signals between the external device and the controller of the device. In this respect, the controller may control an aspect of the device in response to a signal received from an external device. Alternatively or additionally, an external device may respond to a signal received from the device (e.g. from the controller of the device).

In a second aspect, there is provided a system (e.g. a smoking substitute system) comprising a device according to the first aspect and an aerosol-forming article. The aerosol-forming article may comprise an aerosol-forming substrate at an upstream end of the aerosol-forming article. The article may be in the form of a smoking substitute article, e.g. heated tobacco (HT) consumable (also known as a heat-not-burn (HNB) consumable).

As used herein, the terms "upstream" and "downstream" are intended to refer to the flow direction of the vapour/aerosol i.e. with the downstream end of the article/consumable being the mouth end or outlet where the aerosol exits the consumable for inhalation by the user. The upstream end of the article/consumable is the opposing end to the downstream end.

The aerosol-forming substrate is capable of being heated to release at least one volatile compound that can form an aerosol. The aerosol-forming substrate may be located at the upstream end of the article/consumable.

In order to generate an aerosol, the aerosol-forming substrate comprises at least one volatile compound that is intended to be vaporised/aerosolised and that may provide the user with a recreational and/or medicinal effect when inhaled. Suitable chemical and/or physiologically active volatile compounds include the group consisting of: nicotine, cocaine, caffeine, opiates and opoids, cathine and cathinone, kavalactones, mysticin, beta-carboline alkaloids, salvinorin A together with any combinations, functional equivalents to, and/or synthetic alternatives of the foregoing.

The aerosol-forming substrate may comprise plant material. The plant material may comprise least one plant material selected from the list including *Amaranthus dubius, Arctostaphylos uva-ursi* (Bearberry), *Argemone mexicana, Amica, Artemisia vulgaris,* Yellow Tees, *Galea zacatechichi, Canavalia maritima* (Baybean), *Cecropia mexicana* (Guamura), *Cestrum noctumum, Cynoglossum virginianum* (wild comfrey), *Cytisus scoparius, Damiana, Entada rheedii, Eschscholzia califomica* (California Poppy), *Fittonia albivenis, Hippobroma longiflora, Humulus japonica* (Japanese Hops), *Humulus lupulus* (Hops), *Lactuca virosa* (Lettuce Opium), *Laggera alata, Leonotis leonurus, Leonurus cardiaca* (Motherwort), *Leonurus sibiricus* (Honeyweed), *Lobelia cardinalis, Lobelia inflata* (Indian-tobacco), *Lobelia siphilitica, Nepeta cataria* (Catnip), *Nicotiana species* (Tobacco), *Nymphaea alba* (White Lily), *Nymphaea caerulea* (Blue Lily), Opium poppy, *Passiflora incamata* (Passionflower), *Pedicularis densiflora* (Indian Warrior), *Pedicularis groenlandica* (Elephant's Head), *Salvia divinorum, Salvia dorrii* (Tobacco Sage), Salvia species (Sage), *Scutellaria galericulata, Scutellaria lateriflora, Scutellaria nana, Scutellaria* species (Skullcap), *Sida acuta* (Wireweed), *Sida rhombifolia, Silene capensis, Syzygium aromaticum* (Clove), *Tagetes lucida* (Mexican Tarragon), *Tarchonanthus camphoratus, Tumera diffusa* (Damiana), *Verbascum* (Mullein), *Zamia latifolia* (Maconha Brava) together with any combinations, functional equivalents to, and/or synthetic alternatives of the foregoing.

The plant material may be tobacco. Any type of tobacco may be used. This includes, but is not limited to, flue-cured tobacco, burley tobacco, Maryland Tobacco, dark-air cured tobacco, oriental tobacco, dark-fired tobacco, perique tobacco and rustica tobacco. This also includes blends of the above mentioned tobaccos.

The tobacco may comprise one or more of leaf tobacco, stem tobacco, tobacco powder, tobacco dust, tobacco derivatives, expanded tobacco, homogenised tobacco, shredded tobacco, extruded tobacco, cut rag tobacco and/or reconstituted tobacco (e.g. slurry recon or paper recon).

The aerosol-forming substrate may comprise a gathered sheet of homogenised (e.g. paper/slurry recon) tobacco or gathered shreds/strips formed from such a sheet.

The aerosol-forming substrate may comprise one or more additives selected from humectants, flavourants, fillers, aqueous/non-aqueous solvents and binders.

The flavourant may be provided in solid or liquid form. It may include menthol, liquorice, chocolate, fruit flavour (including e.g. citrus, cherry etc.), vanilla, spice (e.g. ginger, cinnamon) and tobacco flavour. The flavourant may be evenly dispersed throughout the aerosol-forming substrate or may be provided in isolated locations and/or varying concentrations throughout the aerosol-forming substrate.

The aerosol-forming substrate may be formed in a substantially cylindrical shape such that the article/consumable resembles a conventional cigarette. It may have a diameter of between 5 and 10mm e.g. between 6 and 9mm or 6 and 8mm e.g. around 7 mm. It may have an axial length of between 10 and 15mm e.g. between 11 and 14mm such as around 12 or 13mm.

The article/consumable may comprise at least one filter element. There may be a terminal filter element at the downstream/mouth end of the article/consumable.

The or at least one of the filter element(s) (e.g. the terminal filter element) may be comprised of cellulose acetate or polypropylene tow. The at least one filter element (e.g. the terminal filter element) may be comprised of activated charcoal. The at least one filter element (e.g. the terminal element) may be comprised of paper. The or each filter element may be at least partly (e.g. entirely) circumscribed with a plug wrap e.g. a paper plug wrap.

The terminal filter element (at the downstream end of the article/consumable) may be joined to the upstream elements forming the article/consumable by a circumscribing tipping layer e.g. a tipping paper layer. The tipping paper may have an axial length longer than the axial length of the terminal filter element such that the tipping paper completely circumscribes the terminal filter element plus the wrapping layer surrounding any adjacent upstream element.

In some embodiments, the article/consumable may comprise an aerosol-cooling element which is adapted to cool the aerosol generated from the aerosol-forming substrate (by heat exchange) before being inhaled by the user.

The article/consumable may comprise a spacer element that defines a space or cavity between the aerosol-forming substrate and the downstream end of the consumable. The spacer element may comprise a cardboard tube. The spacer element may be circumscribed by the (paper) wrapping layer.

According to a third aspect of the present invention, there is provided a method of using the system according to the second aspect, the method comprising inserting the aerosol-forming article into the device; and heating the article using the heater of the device.

In some embodiments the method may comprise inserting the article into a cavity within a body of the device and penetrating the article with the heating element of the device upon insertion of the article.

The invention includes the combination of the aspects and preferred features described except where such a combination is clearly impermissible or expressly avoided.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### SUMMARY OF THE FIGURES

So that the invention may be understood, and so that further aspects and features thereof may be appreciated, embodiments illustrating the principles of the invention will now be discussed in further detail with reference to the accompanying figures, in which:
Figure 1 is a schematic of a smoking substitute system;
Figure 2A is a front view of a first embodiment of a smoking substitute system with the consumable engaged with the device;
Figure 2B is a front view of the first embodiment of the smoking substitute system with the consumable disengaged from the device;
Figure 2C is a section view of the consumable of the first embodiment of the smoking substitute system;
Figure 2D is a detailed view of an end of the device of the first embodiment of the smoking substitute system;
Figure 2E is a section view of the first embodiment of the substitute smoking system;
Figure 3A is a schematic of a smoking substitute device according to a second embodiment of the present invention;
Figure 3B is a schematic of a PCB of the second embodiment; and
Figure 3C is an exemplary circuit diagram of a transistor arrangement of the second embodiment.

### DETAILED DESCRIPTION OF THE INVENTION

Aspects and embodiments of the present invention will now be discussed with reference to the accompanying figures. Further aspects and embodiments will be apparent to those skilled in the art. All documents mentioned in this text are incorporated herein by reference.

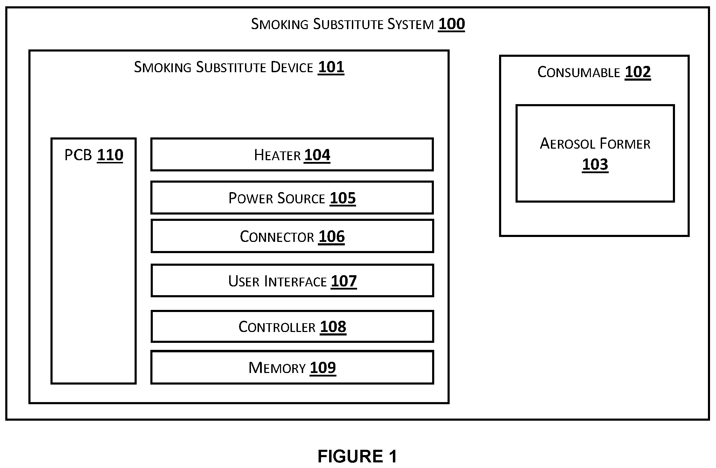

Figure 1 is a schematic providing a general overview of a smoking substitute system 100. The system 100 includes a substitute smoking device 101 and an aerosol-forming article in the form of a consumable 102, which comprises an aerosol former 103. The system is configured to vaporise the aerosol former by heating the aerosol former 103 (so as to form a vapour/aerosol for inhalation by a user).

In the illustrated system, the heater 104 forms part of the device 101 and is configured to heat the aerosol former 103. Heat from the heater 104 vaporises the aerosol former 103 to produce a vapour. The vapour subsequently condenses to form an aerosol, which is ultimately inhaled by the user. In one aspect, the heater 104 comprises a heating track (not shown) and a temperature sensing track (not shown) for measuring the temperature of the heater 104.

The system 100 further comprises a power source 105 that forms part of the device 101. In other embodiments the power source 105 may be external to (but connectable to) the device 101. The power source 105 is electrically connectable to the heater 104 such that the power source 105 is able to supply power to the heater 104 (i.e. for the purpose of heating the aerosol former 103). Thus, control of the electrical connection of the power source 105 to the heater 104 provides control of the state of the heater 104. The power source 105 may be a power store, for example a battery or rechargeable battery (e.g. a lithium ion battery).

The system 100 further comprises an I/O module comprising a connector 106 (e.g. in the form of a USB port, Micro USB port, USB-C port, etc.). The connector 106 is configured for connection to an external source of electrical power, e.g. a mains electrical supply outlet. The connector 106 may be used in substitution for the power source 105. That is the connector 106 may be electrically connectable to the heater 104 so as to supply electricity to the heater 104. In such embodiments, the device may not include a power source, and the power source of the system may instead comprise the connector 106 and an external source of electrical power (to which the connector 106 provides electrical connection).

In some embodiments, the connector 106 may be used to charge and recharge the power source 105 where the power source 105 includes a rechargeable battery.

The system 100 also comprises a user interface (UI) 107. Although not shown, the UI 107 may include input means to receive commands from a user. The input means of the UI 107 allows the user to control at least one aspect of the operation of the system 100. The input means may, for example, be in the form of a button, touchscreen, switch, microphone, etc.

The UI 107 also comprises output means to convey information to the user. The output means may, for example, comprise lights (e.g. LEDs), a display screen, speaker, vibration generator, etc.

The system 100 further comprises a controller 108 that is configured to control at least one function of the device 101. In the illustrated embodiment, the controller 108 is a component of the device 101, but in other embodiments may be separate from (but connectable to) the device 101. The controller 108 is configured to control the operation of the heater 104 and, for example, may be configured to control the voltage applied from the power source 105 to the heater 104. The controller 108 may be configured to toggle the supply of power to the heater 105 between an on state, in which the full output voltage of the power source 105 is applied to the heater 104, and an off state, in which the no voltage is applied to the heater 104.

The system 100 further comprises a printed circuit board (PCB) 110 with a power layer, a ground layer and top and bottom layers. The power and ground layers are sandwiched between the top and bottom layers.

Although not shown, the system 100 may also comprise a voltage regulator to regulate the output voltage from the power source 105 to form a regulated voltage. The regulated voltage may then be applied to the heater 104. The power layer of the PCB 110 is connected to the output of the voltage regulator.

In addition to being connected to the heater 104, the controller 108 is operatively connected to the UI 107. Thus, the controller 108 may receive an input signal from the input means of the UI 107. Similarly, the controller 108 may transmit output signals to the UI 107. In response, the output means of the UI 107 may convey information, based on the output signals, to a user.

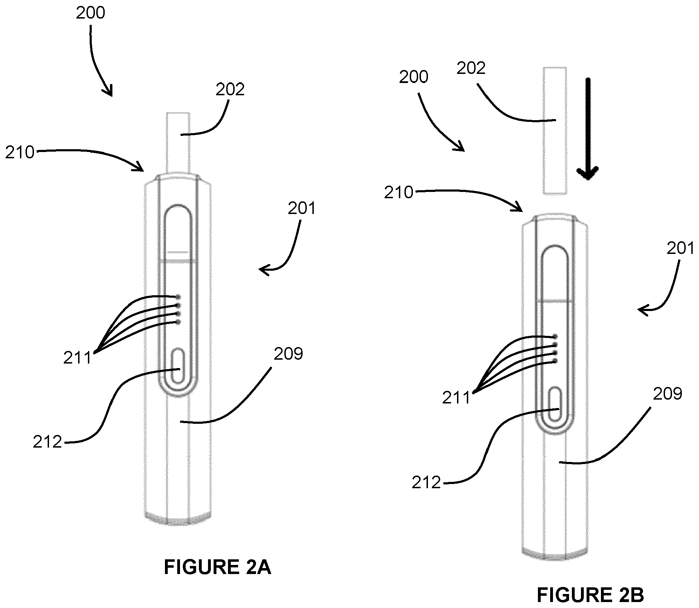

Figures 2A and 2B illustrate a heated-tobacco (HT) smoking substitute system 200. The system 200 is an example of the systems 100 described in relation to Figure 1. System 200 includes an HT device 201 and an HT consumable 202. The description of Figure 1 above is applicable to the system 200 of Figures 2A and 2B, and will thus not be repeated.

The device 201 and the consumable 202 are configured such that the consumable 202 can be engaged with the device 201. Figure 2A shows the device 201 and the consumable 202 in an engaged state, whilst Figure 2B shows the device 201 and the consumable 202 in a disengaged state.

The device 201 comprises a body 209 and cap 210. In use the cap 210 is engaged at an end of the body 209. Although not apparent from the figures, the cap 210 is moveable relative to the body 209. In particular, the cap 210 is slideable and can slide along a longitudinal axis of the body 209. The device 201 comprises an output means (forming part of the UI of the device 201) in the form of a plurality of light-emitting diodes (LEDs) 211 arranged linearly along the longitudinal axis of the device 201 and on an outer surface of the body 209 of the device 201. A button 212 is also arranged on an outer surface of the body 209 of the device 201 and is axially spaced (i.e. along the longitudinal axis) from the plurality of LEDs 211.

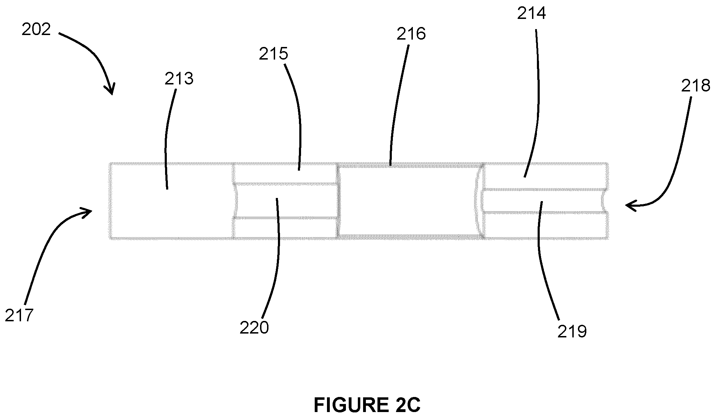

Figure 2C show a detailed section view of the consumable of 202 of the system 200. The consumable 202 generally resembles a cigarette. In that respect, the consumable 202 has a generally cylindrical form with a diameter of 7 mm and an axial length of 70 mm. The consumable 202 comprises an aerosol forming substrate 213, a terminal filter element 214, an upstream filter element 215 and a spacer element 216. In other embodiments, the consumable may further comprise a cooling element. A cooling element may exchange heat with vapour that is formed by the aerosol-forming substrate 213 in order to cool the vapour so as to facilitate condensation of the vapour.

The aerosol-forming substrate 213 is substantially cylindrical and is located at an upstream end 217 of the consumable 202, and comprises the aerosol former of the system 200. In that respect, the aerosol forming substrate 213 is configured to be heated by the device 201 to release a vapour. The released vapour is subsequently entrained in an airflow flowing through the aerosol-forming substrate 213. The airflow is produced by the action of the user drawing on a downstream 218 (i.e. terminal or mouth end) of the consumable 202.

In the present embodiment, the aerosol forming substrate 213 comprises tobacco material that may, for example, include any suitable parts of the tobacco plant (e.g. leaves, stems, roots, bark, seeds and flowers). The tobacco may comprise one or more of leaf tobacco, stem tobacco, tobacco powder, tobacco dust, tobacco derivatives, expanded tobacco, homogenised tobacco, shredded tobacco, extruded tobacco, cut rag tobacco and/or reconstituted tobacco (e.g. slurry recon or paper recon). For example, the aerosol-forming substrate 213 may comprise a gathered sheet of homogenised (e.g. paper/slurry recon) tobacco or gathered shreds/strips formed from such a sheet.

In order to generate an aerosol, the aerosol forming substrate 213 comprises at least one volatile compound that is intended to be vaporised/aerosolised and that may provide the user with a recreational and/or medicinal effect when inhaled. The aerosol-forming substrate 213 may further comprise one or more additives. For example, such additives may be in the form of humectants (e.g. propylene glycol and/or vegetable glycerine), flavourants, fillers, aqueous/non-aqueous solvents and/or binders.

The terminal filter element 214 is also substantially cylindrical, and is located downstream of the aerosol forming substrate 213 at the downstream end 218 of the consumable 202. The terminal filter element 214 is in the form of a hollow bore filter element having a bore 219 (e.g. for airflow) formed therethrough. The diameter of the bore 219 is 2 mm. The terminal filter element 214 is formed of a porous (e.g. monoacetate) filter material. As set forth above, the downstream end 218 of the consumable 202 (i.e. where the terminal filter 214 is located) forms a mouthpiece portion of the consumable 202 upon which the user draws. Airflow is drawn from the upstream end 217, thorough the components of the consumable 202, and out of the downstream end 218. The airflow is driven by the user drawing on the downstream end 218 (i.e. the mouthpiece portion) of the consumable 202.

The upstream filter element 215 is located axially adjacent to the aerosol-forming substrate 213, between the aerosol-forming substrate 213 and the terminal filter element 214. Like the terminal filter 214, the upstream filter element 215 is in the form of a hollow bore filter element, such that it has a bore 220 extending axially therethrough. In this way, the upstream filter 215 may act as an airflow restrictor. The upstream filter element 215 is formed of a porous (e.g. monoacetate) filter material. The bore 220 of the upstream filter element 214 has a larger diameter (3 mm) than the terminal filter element 214.

The spacer 216 is in the form of a cardboard tube, which defines a cavity or chamber between the upstream filter element 215 and the terminal filter element 214. The spacer 216 acts to allow both cooling and mixing of the vapour/aerosol from the aerosol-forming substrate 213. The spacer has an external diameter of 7 mm and an axial length of 14mm.

Although not apparent from the figure, the aerosol-forming substrate 213, upstream filter 215 and spacer 216 are circumscribed by a paper wrapping layer. The terminal filter 214 is circumscribed by a tipping layer that also circumscribes a portion of the paper wrapping layer (so as to connect the terminal filter 214 to the remaining components of the consumable 202). The upstream filter 215 and terminal filter 214 are circumscribed by further wrapping layers in the form of plug wraps.

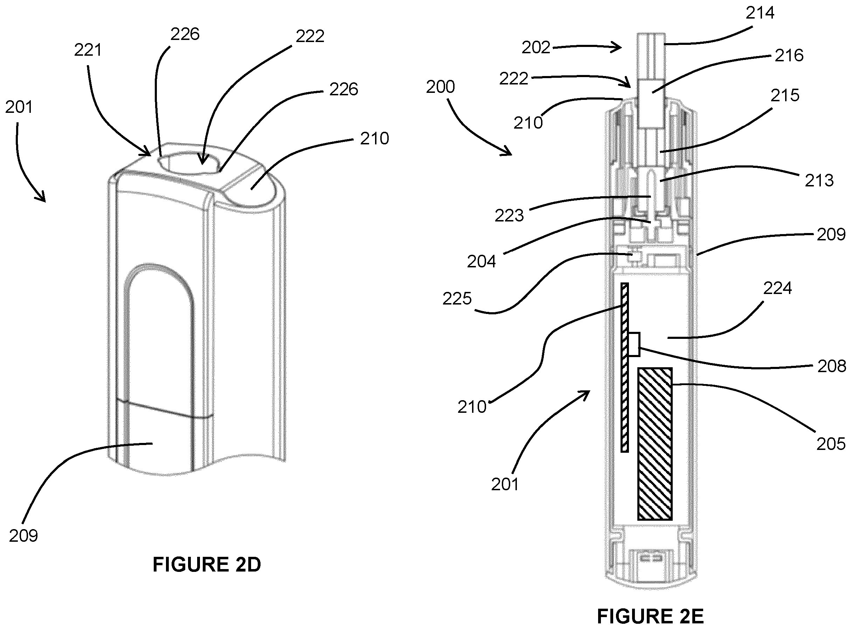

Returning now to the device 201, Figure 2D illustrates a detailed view of the end of the device 201 that is configured to engage with the consumable 202. The cap 210 of the device 201 includes an opening 221 to an internal cavity 222 (more apparent from Figure 2D) defined by the cap 210. The opening 221 and the cavity 222 are formed so as to receive at least a portion of the consumable 202. During engagement of the consumable 202 with the device 201, a portion of the consumable 202 is received through the opening 221 and into the cavity 222. After engagement (see Figure 2B), the downstream end 218 of the consumable 202 protrudes from the opening 221 and thus protrudes also from the device 201. The opening 221 includes laterally disposed notches 226. When a consumable 202 is received in the opening 221, these notches 226 remain open and could, for example, be used for retaining a cover to cover the end of the device 201.

Figure 2E shows a cross section through a central longitudinal plane through the device 201. The device 201 is shown with the consumable 202 engaged therewith.

The device 201 comprises a heater 204 comprising heating element 223. The heater 204 forms part of the body 209 of the device 201 and is rigidly mounted to the body 209. In the illustrated embodiment, the heater 204 is a rod heater with a heating element 223 having a circular transverse profile. In other embodiments the heater may be in the form of a blade heater (e.g. heating element with a rectangular transverse profile) or a tube heater (e.g. heating element with a tubular form).

The heating element 223 of the heater 204 projects from an internal base of the cavity 222 along a longitudinal axis towards the opening 221. As is apparent from the figure, the length (i.e. along the longitudinal axis) of the heating element is less than a depth of the cavity 222. In this way, the heating element 223 does not protrude from or extend beyond the opening 221.

When the consumable 202 is received in the cavity 222 (as is shown in Figure 2E), the heating element 223 penetrates the aerosol-forming substrate 213 of the consumable 202. In particular, the heating element 223 extends for nearly the entire axial length of the aerosol-forming substrate 213 when inserted therein. Thus, when the heater 204 is activated, heat is transferred radially from an outer circumferential surface the heating element 223 to the aerosol-forming substrate 213.

The device 201 further comprises an electronics cavity 224. A power source, in the form of a rechargeable battery 205 (a lithium ion battery), is located in electronics cavity 224.

The device 201 comprises a controller 208 is configured to control at least one function of the device 201 and that is electrically connected to a PCB 210. The controller is configured to control the operation of the heater 204, which includes toggling the electrical connection of the rechargeable battery 205 to the heater 204. As will be described further below this toggling of the electrical connection is done by way of transistors (also electrically connected to the PCB). For example, the controller is configured to control the heater 204 in response to a user depressing the button 212. Depressing the button 212 may cause the controller to allow a voltage (from the rechargeable battery 205) to be applied to the heater 204 (so as to cause the heating element 223 to be heated).The controller is also configured to control the LEDs 211 in response to (e.g. a detected) a condition of the device 201 or the consumable 202. For example, the controller may control the LEDs to indicate whether the device 201 is in an on state or an off state (e.g. one or more of the LEDs may be illuminated by the controller when the device is in an on state).

The device 201 comprises a further input means (i.e. in addition to the button 212) in the form of a puff sensor 225. The puff sensor 225 is configured to detect a user drawing (i.e. inhaling) at the downstream end 218 of the consumable 202. The puff sensor 225 may, for example, be in the form of a pressure sensor, flowmeter or a microphone. The puff sensor 225 is operatively connected to the controller in the electronics cavity 224, such that a signal from the puff sensor 225, indicative of a puff state (i.e. drawing or not drawing), forms an input to the controller (and can thus be responded to by the controller).

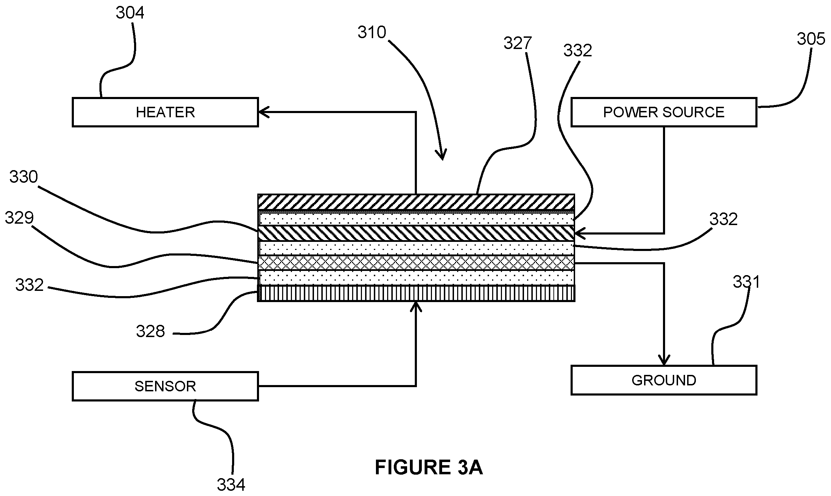

Figure 3A is a schematic providing an exemplary PCB 310 connected to a number of components of a device. Such an arrangement may, for example, be used with the device 201 described above. As is apparent from the figure, the PCB 310 is a multilayer PCB and, in particular, includes four layers. The PCB 310 comprises top 327 and bottom 328 layers for electrically connecting and supporting a number of components (e.g. controllers, transistors, etc.). The PCB 310 further comprises a ground layer 329 and a power layer 330. The power layer 330 is electrically connected to a power source 305 and the ground layer 329 is electrically connected to ground 331 (e.g. such as a ground terminal of the power source 305).

The layers are separated by insulative layers 332 that may be formed of prepreg. However, although not shown, the top 327 and bottom 328 layers are electrically connected to the ground 329 and power 330 layers by way of e.g. vias (that extend transversely across the PCB 310). In this way, power from the power source 305 is supplied to components supported by and/or connected to the top 327 and bottom 328 layers of the PCB 310. As an example, the top layer 327 may be electrically connected to a heater 304 of the device and the bottom layer 328 may be connected to a sensor, such as a temperture sensor 334.

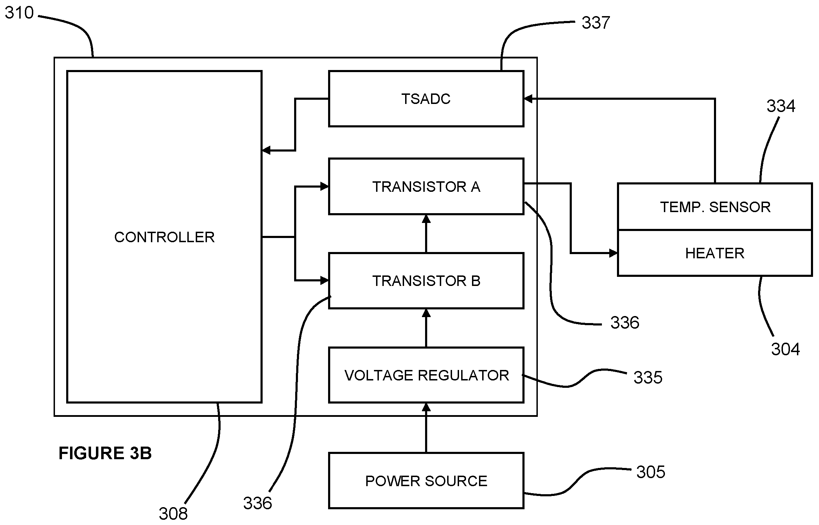

Traces (i.e. printed circuits) on the PCB 310 allow the heater 304 and sensor 325 to communicate with components (such as a controller) electrically connected to the PCB 310. Figure 3B shows how these components may be arranged in more detail. In this figure, a power source 305, heater 304 and temperature sensor 334 are connected to the PCB 310. The PCB 310 comprises a voltage regulator 335, two transistors 336 and a temperature sensor analog-to-digital convertor (TSADC) 337.

The power source 305 supplies power to the heater 304, via the voltage regulator 335 and the transistors 336. The voltage regulator 335 ensures a consistent voltage is applied to the PCB 310 and the transistors 336 provide control of the power supply to the heater 304.

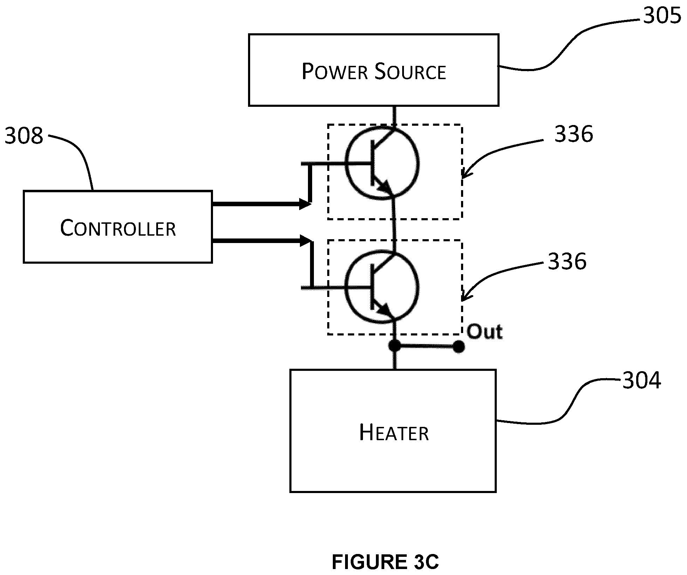

The controller 308 is connected to both transistors 336 via the same output such that a single signal from the controller 308 controls both transistors 336 (i.e. between on and off conditions) simultaneously. The transistors 336 are arranged in series, such that if one transistor 336 fails, so as to be stuck in an on condition, switching the other transistor 336 to the off condition will prevent supply of power to the heater 304 (see Figure 3C, which shows this arrangement in more detail).

The arrangement further comprises a temperature sensor 334, in the form of a temperature sensing track that is mounted to a heating element of the heater 304 so as to be able to measure the temperature of the heater 304. This temperature sensor 334 is connected to the controller 308 via the TSADC 337, so as to supply a signal indicative of the temperature of the heater 304 to the controller 308. In this way, the controller 308 can control the transistors 336 (and thus the heater 304) in response to this signal. For example, if the sensed temperature exceeds a predetermined desired value, the controller 308 may control the transistors 336 to prevent power supply to the heater 304. The controller 308 may continue to receive temperature signals and, once the temperature falls below the desired value, the controller 308 may control the transistors 336 to allow power supply to the heater 304.

Whilst not shown, the controller 308 may also be configured to detect whether there is a short circuit in the heater 304. This may, for example, be performed by detecting an impedance of the heater 304. If the impedance falls below a threshold value, the controller 308 may control the transistors 336 to prevent supply of power to the heater 304.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the words "have", "comprise", and "include", and variations such as "having", "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means, for example, +/- 10%.

The words "preferred" and "preferably" are used herein refer to embodiments of the invention that may provide certain benefits under some circumstances. It is to be appreciated, however, that other embodiments may also be preferred under the same or different circumstances. The recitation of one or more preferred embodiments therefore does not mean or imply that other embodiments are not useful, and is not intended to exclude other embodiments from the scope of the disclosure, or from the scope of the claims.

## Claims

1. A heated tobacco device (101, 201) comprising:
a power source (105, 205, 305);
a heater (104, 204, 304); and
a printed circuit board "PCB" (110, 210, 310) comprising a power layer (330) connected to the power source (105, 205, 305), a ground layer (329), a top layer (327) and a bottom layer (328), wherein the top and bottom layers (327, 328) are configured to electrically connect and support one or more components, **characterised in that** the power and ground layers (330, 329) are sandwiched between the top and bottom layers (327, 328).

2. A device (101, 201) according to claim 1, further comprising a voltage regulator (335) to regulate the voltage supplied by the power source (105, 205, 305) to a regulated voltage value at an output of the voltage regulator.

3. A device (101, 201) according to claim 2, wherein the power layer (330) is connected to the output of the voltage regulator (335).

4. A device (101, 201) according to any one of the preceding claims comprising a first heater control transistor configured to control the supply of power to the heater (104, 204, 304) from the power source (105, 205, 305).

5. A device (101, 201) according to claim 4 further comprising a second heater control transistor connected in series with the first transistor, the second transistor configured to control the supply of power to the heater (104, 204, 304) from the power source (105, 205, 305).

6. A device (101, 201) according to claim 5, wherein the first and second transistors are on the return path from the heater (104, 204, 304) to the power source (105, 205, 305).

7. A device (101, 201) according to any one claims 4 to 6, further comprising a controller (308) connected to a first drive input of the first transistor and a second drive input of the second transistor.

8. A device (101, 201) according to claim 7, wherein the first drive input and the second drive input are connected to the same output of the controller (308).

9. A device (101, 201) according to claim 7, wherein the first drive input and the second drive input are connected to different outputs of the controller (308).

10. A device (101, 201) according to any one of the preceding claims, wherein the heater (104, 204, 304) comprises a heating track and the PCB (110, 210, 310) comprises a heater analog-to-digital converter (HADC) connected to the heater (104, 204, 304), the controller (308) configured to identify a short circuit in the heating track of the heater (104, 204, 304) using the input to the HADC.

11. A device (101, 201) according to any one of the preceding claims, wherein the heater (104, 204, 304) comprises a temperature sensing track for sensing a temperature of the heater (104, 204, 304), the PCB (110, 210, 310) comprising a temperature sensing analog-to-digital converter (TSADC) connected to the temperature sensing track.

12. The device (101, 201) according to claim 11, wherein the controller (308) is configured to determine the temperature of the temperature sensing track using the input to the TSADC.

13. A device (101, 201) according to claim 11 or 12 wherein the controller (308) is configured to determine if the impedance of the temperature sensing track is outside a predetermined operating range, and to prevent power supply to the heater (104, 204, 304) if the impedance is outside the predetermined operating range.

## Patentansprüche

1. Beheizte Tabakvorrichtung (101, 201), die Folgendes umfasst:
eine Leistungsquelle (105, 205, 305);
eine Heizvorrichtung (104, 204, 304); und
eine gedruckte Leiterplatte "PCB" (110, 210, 310), die eine Leistungsschicht (330), die mit der Leistungsquelle (105, 205, 305) verbunden ist, eine Masseschicht (329), eine obere Schicht (327) und eine untere Schicht (328) umfasst, wobei die obere und die untere Schicht (327, 328) ausgelegt sind, um eine oder mehrere Komponenten elektrisch zu verbinden und zu tragen, **dadurch gekennzeichnet, dass** die Leistungsschicht und die Masseschicht (330, 329) sandwichartig zwischen der oberen und der unteren Schicht (327, 328) angeordnet sind.

2. Vorrichtung (101, 201) nach Anspruch 1, die weiters einen Spannungsregler (335) umfasst, um die Spannung, die durch die Leistungsquelle (105, 205, 305) bereitgestellt ist, auf einen geregelten Spannungswert an einem Ausgang des Spannungsreglers zu regeln.

3. Vorrichtung (101, 201) nach Anspruch 2, wobei die Leistungsschicht (330) mit dem Ausgang des Spannungsreglers (335) verbunden ist.

4. Vorrichtung (101, 201) nach einem der vorangegangenen Ansprüche, die einen ersten Heizvorrichtungssteuertransistor umfasst, der ausgelegt ist, um die Leistungszufuhr zur Heizvorrichtung (104, 204, 304) von der Leistungsquelle (105, 205, 305) zu steuern.

5. Vorrichtung (101, 201) nach Anspruch 4, die weiters einen zweiten Heizvorrichtungssteuertransistor umfasst, der mit dem ersten Transistor in Reihe geschaltet ist, wobei der zweite Transistor ausgelegt ist, um die Leistungszufuhr zur Heizvorrichtung (104, 204, 304) von der Leistungsquelle (105, 205, 305) zu steuern.

6. Vorrichtung (101, 201) nach Anspruch 5, wobei der erste und zweite Transistor auf dem Rückführungsweg von der Heizvorrichtung (104, 204, 304) zur Leistungsquelle (105, 205, 305) sind.

7. Vorrichtung (101, 201) nach einem der Ansprüche 4 bis 6, die weiters eine Steuerung (308) umfasst, die mit einem ersten Ansteuereingang des ersten Transistors und einem zweiten Ansteuereingang des zweiten Transistors verbunden ist.

8. Vorrichtung (101, 201) nach Anspruch 7, wobei der erste Ansteuereingang und der zweite Ansteuereingang mit demselben Ausgang der Steuerung (308) verbunden sind.

9. Vorrichtung (101, 201) nach Anspruch 7, wobei der erste Ansteuereingang und der zweite Ansteuereingang mit unterschiedlichen Ausgängen der Steuerung (308) verbunden sind.

10. Vorrichtung (101, 201) nach einem der vorangegangenen Ansprüche, wobei die Heizvorrichtung (104, 204, 304) eine Heizbahn umfasst und die PCB (110, 210, 310) einen Heizvorrichtung-Analog-Digital-Wandler (HADC) umfasst, der mit der Heizvorrichtung (104, 204, 304) verbunden ist, wobei die Steuerung (308) ausgelegt ist, um einen Kurzschluss in der Heizbahn der Heizvorrichtung (104, 204, 304) unter Verwendung des Eingangs in den HADC zu identifizieren.

11. Vorrichtung (101, 201) nach einem der vorangegangenen Ansprüche, wobei die Heizvorrichtung (104, 204, 304) eine Temperaturabfühlbahn zum Abfühlen der Temperatur der Heizvorrichtung (104, 204, 304) umfasst, wobei die PCB (110, 210, 310) einen die Temperatur abfühlenden Analog-Digital-Wandler (TSADC) umfasst, der mit der Temperaturabfühlbahn verbunden ist.

12. Vorrichtung (101, 201) nach Anspruch 11, wobei die Steuerung (308) ausgelegt ist, um die Temperatur der Temperaturabfühlbahn unter Verwendung des Eingangs in den TSADC zu bestimmen.

13. Vorrichtung (101, 201) nach Anspruch 11 oder 12, wobei die Steuerung (308) ausgelegt ist, um zu bestimmen, ob die Impedanz der Temperaturabfühlbahn außerhalb eines vorbestimmten Betriebsbereichs liegt, und um Leistungszufuhr zur Heizvorrichtung (104, 204, 304) zu verhindern, wenn die Impedanz außerhalb des vorbestimmten Betriebsbereichs liegt.

## Revendications

1. Dispositif à tabac chauffé (101, 201), comprenant :
une source d'alimentation (105, 205, 305) ;
un dispositif de chauffage (104, 204, 304) ; et
une carte de circuit imprimé « PCB » (110, 210, 310) comprenant une couche d'alimentation (330) connectée à la source d'alimentation (105, 205, 305), une couche de masse (329), une couche supérieure (327) et une couche inférieure (328), dans lequel les couches supérieure et inférieure (327, 328) sont configurées pour connecter électriquement et supporter un ou plusieurs composants, **caractérisée en ce que** les couches d'alimentation et de masse (330, 329) sont enserrées entre les couches supérieure et inférieure (327, 328).

2. Dispositif (101, 201) selon la revendication 1, comprenant en outre un régulateur de tension (335) pour réguler la tension fournie par la source d'alimentation (105, 205, 305) à une valeur de tension régulée au niveau d'une sortie du régulateur de tension.

3. Dispositif (101, 201) selon la revendication 2, dans lequel la couche d'alimentation (330) est connectée à la sortie du régulateur de tension (335).

4. Dispositif (101, 201) selon l'une quelconque des revendications précédentes, comprenant un premier transistor de commande de dispositif de chauffage configuré pour commander l'alimentation du dispositif de chauffage (104, 204, 304) à partir de la source d'alimentation (105, 205, 305).

5. Dispositif (101, 201) selon la revendication 4, comprenant en outre un second transistor de commande de dispositif de chauffage connecté en série avec le premier transistor, le second transistor étant configuré pour commander l'alimentation du dispositif de chauffage (104, 204, 304) à partir de la source d'alimentation (105, 205, 305).

6. Dispositif (101, 201) selon la revendication 5, dans lequel les premier et second transistors sont sur le trajet de retour du dispositif de chauffage (104, 204, 304) à la source d'alimentation (105, 205, 305).

7. Dispositif (101, 201) selon l'une quelconque des revendications 4 à 6, comprenant en outre un dispositif de commande (308) connecté à une première entrée d'entraînement du premier transistor et à une seconde entrée d'entraînement du second transistor.

8. Dispositif (101, 201) selon la revendication 7, dans lequel la première entrée d'entraînement et la seconde entrée d'entraînement sont connectées à la même sortie du dispositif de commande (308).

9. Dispositif (101, 201) selon la revendication 7, dans lequel la première entrée d'entraînement et la seconde entrée d'entraînement sont connectées à des sorties différentes du dispositif de commande (308).

10. Dispositif (101, 201) selon l'une quelconque des revendications précédentes, dans lequel le dispositif de chauffage (104, 204, 304) comprend une piste de chauffage et la PCB (110, 210, 310) comprend un convertisseur analogique-numérique de dispositif de chauffage (HADC) connecté au dispositif de chauffage (104, 204, 304), le dispositif de commande (308) étant configuré pour identifier un court-circuit dans la piste de chauffage du dispositif de chauffage (104, 204, 304) en utilisant l'entrée vers le HADC.

11. Dispositif (101, 201) selon l'une quelconque des revendications précédentes, dans lequel le dispositif de chauffage (104, 204, 304) comprend une piste de détection de température pour détecter une température du dispositif de chauffage (104, 204, 304), la PCB (110, 210, 310) comprenant un convertisseur analogique-numérique de détection de température (TSADC) connecté à la piste de détection de température.

12. Dispositif (101, 201) selon la revendication 11, dans lequel le dispositif de commande (308) est configuré pour déterminer la température de la piste de détection de température en utilisant l'entrée vers le TSADC.

13. Dispositif (101, 201) selon la revendication 11 ou 12, dans lequel le dispositif de commande (308) est configuré pour déterminer si l'impédance de la piste de détection de température est en dehors d'une plage de fonctionnement prédéterminée, et pour empêcher une alimentation électrique du dispositif de chauffage (104, 204, 304) si l'impédance est en dehors de la plage de fonctionnement prédéterminée.
